(19) Europäisches Patentamt
European Patent Office
Office européen des brevets

(11) **EP 4 383 331 A1**

(12) **EUROPEAN PATENT APPLICATION**
published in accordance with Art. 153(4) EPC

(43) Date of publication:
**12.06.2024 Bulletin 2024/24**

(21) Application number: **22852578.8**

(22) Date of filing: **22.03.2022**

(51) International Patent Classification (IPC):
**H01L 27/146** (2006.01)   **G02B 5/30** (2006.01)

(52) Cooperative Patent Classification (CPC):
**G02B 5/30; H01L 27/146**

(86) International application number:
**PCT/JP2022/013043**

(87) International publication number:
**WO 2023/013149 (09.02.2023 Gazette 2023/06)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **06.08.2021   JP 2021130145**

(71) Applicant: **Sony Group Corporation
Tokyo 108-0075 (JP)**

(72) Inventors:
• **MORITA, Hiroki
Tokyo 108-0075 (JP)**
• **AKIBA, Akira
Tokyo 108-0075 (JP)**

(74) Representative: **MFG Patentanwälte
Meyer-Wildhagen Meggle-Freund
Gerhard PartG mbB
Amalienstraße 62
80799 München (DE)**

(54) **SOLID-STATE IMAGE CAPTURING DEVICE**

(57)   [Object]
Provided is a solid-state imaging device having a metasurface structure with which light can be condensed on the center of each pixel even if the light obliquely enters a pixel region.

[Solving Means]
A solid-state imaging device according to the present embodiment includes a pixel region that includes multiple pixels, and a polarization control element that is disposed above an incidence surface of the pixel region on which incident light is incident and that includes multiple microstructures which are two-dimensionally arranged in substantially parallel with the incidence surface. Of the multiple microstructures corresponding to a first pixel included in the pixel region, a first microstructure has a maximum length in a first polarization direction of the incident light, and a position of the first microstructure in the first pixel depends on the distance from the center of the pixel region to the first pixel.

FIG.2

**Description**

[Technical Field]

The present technology relates to a solid-state imaging device.

[Background Art]

In recent years, polarization imaging in which imaging is performed using multidimensional information that includes polarization information regarding light from a subject is under development for solid-state imaging devices which are used for on-vehicle cameras, IoT (Internet of Things) devices, medical devices, etc. In order to obtain polarization information for such polarization imaging, a metasurface structure having a polarized-light separation function has been used in some cases.

[Citation List]

[Patent Literature]

[PTL 1]
Japanese Patent Laid-open No. 2020-051868

[Summary]

[Technical Problem]

With a conventional metasurface structure, however, light having obliquely entered a light incidence surface of a pixel region cannot be condensed on the center of each pixel. In other words, exit pupil correction cannot be performed with the metasurface structure.
In view of this, the present disclosure provides a solid-state imaging device having a metasurface structure with which light can be condensed on the center of each pixel even if the light obliquely enters a pixel region.

[Solution to Problem]

A solid-state imaging device according to one aspect of the present disclosure includes a pixel region that includes multiple pixels, and a polarization control element that is disposed above an incidence surface of the pixel region on which incident light is incident and that includes multiple microstructures which are two-dimensionally arranged in substantially parallel with the incidence surface, in which, of the multiple microstructures corresponding to a first pixel included in the pixel region, a first microstructure has a maximum length in a first polarization direction of the incident light, and a position of the first microstructure in the first pixel depends on a distance from the center of the pixel region to the first pixel.
A distance from the position of the first microstructure in the first pixel to the center of the first pixel increases with an increase of the distance from the center of the pixel region to the first pixel.
The distance from the position of the first microstructure in the first pixel to the center of the first pixel increases with an increase of an inclination angle of the incident light with respect to a direction perpendicular to the incidence surface.
Of the multiple microstructures corresponding to a second pixel included in the pixel region, a second microstructure has a maximum length in a second polarization direction of the incident light substantially orthogonal to the first polarization direction, and a position of the second microstructure in the second pixel depends on a distance from the center of the pixel region to the second pixel.
A distance from the position of the second microstructure in the second pixel to the center of the second pixel increases with an increase of the distance from the center of the pixel region to the second pixel.
The distance from the position of the second microstructure in the second pixel to the center of the second pixel increases with an increase of an inclination angle of the incident light with respect to a direction perpendicular to the incidence surface.
In the first pixel, the multiple microstructures have, in the first polarization direction, a length that becomes shorter with an increase of a distance from the first microstructure.
In the second pixel, the multiple microstructures have, in the second polarization direction, a length that becomes shorter with an increase of a distance from the second microstructure.

The multiple microstructures have, in the first polarization direction, a length that is restored to be equal to a length of the first microstructure, at every given distance from the first microstructure.

The multiple microstructures have, in the second polarization direction, a length that is restored to be equal to the length of the second microstructure, at every given distance from the second microstructure.

Of the multiple microstructures corresponding to a third pixel included in the pixel region, a third microstructure has a maximum length in a third polarization direction that is inclined from the first and second polarization directions of the incident light, and a position of the third microstructure in the third pixel depends on a distance from the center of the pixel region to the third pixel.

A distance from the position of the third microstructure in the third pixel to the center of the third pixel increases with an increase of the distance from the center of the pixel region to the third pixel.

The distance from the position of the third microstructure in the third pixel to the center of the third pixel increases with an increase of an inclination angle of the incident light with respect to a direction perpendicular to the incidence surface.

The solid-state imaging device further includes multiple polarization control elements that are disposed above the incidence surface and are layered.

[Brief Description of Drawings]

[FIG. 1]

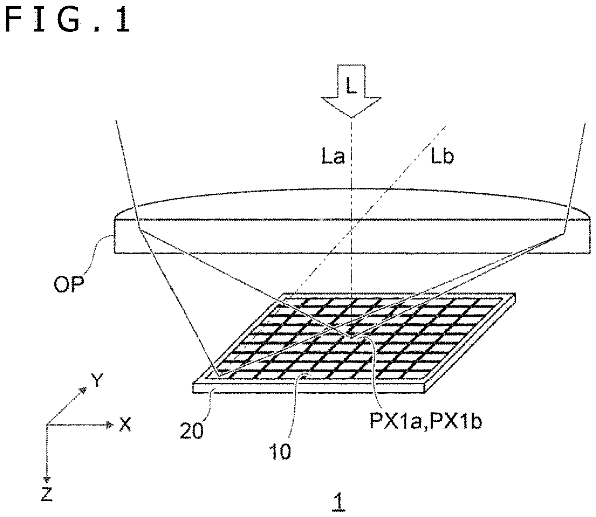

FIG. 1 is a schematic view of a configuration example of a solid-state imaging device according to a first embodiment.
[FIG. 2]

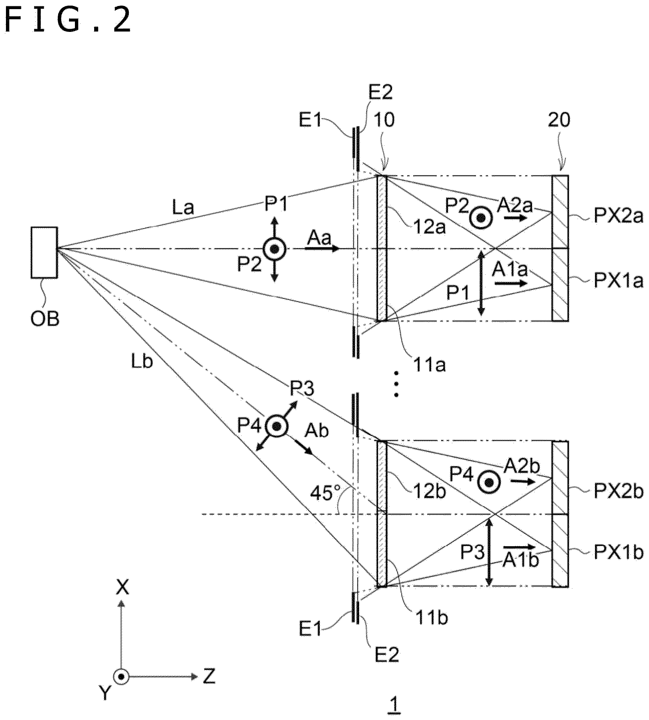

FIG. 2 is a schematic view of a more detailed configuration example of a polarization control unit and a pixel region.
[FIG. 3]

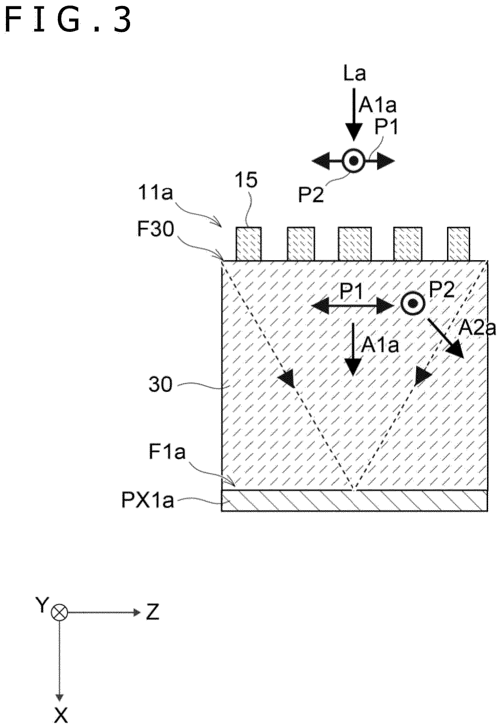

FIG. 3 is a cross-sectional view of a configuration example of a polarization control element and a pixel.
[FIG. 4]

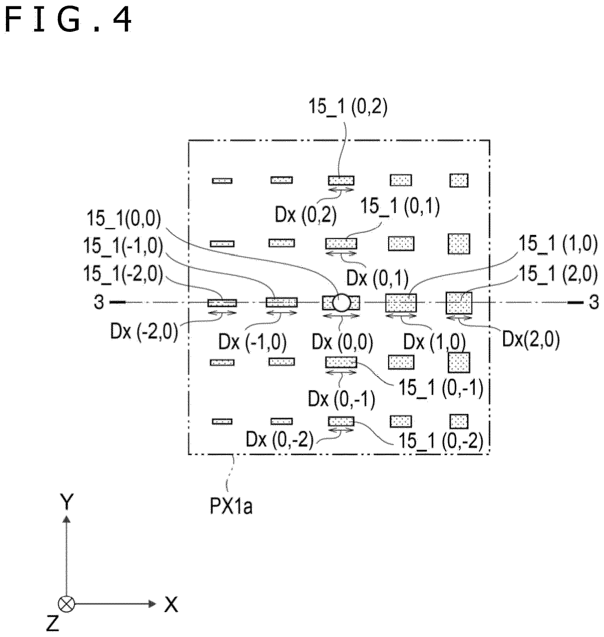

FIG. 4 is a plan view of one example of a metasurface structure of a polarization control element.
[FIG. 5]

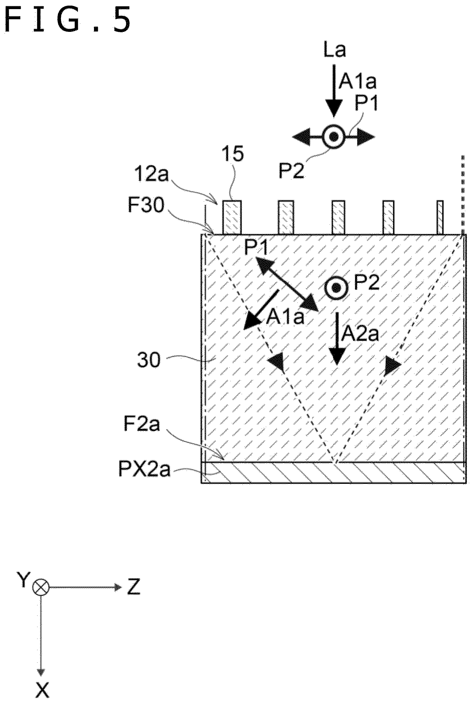

FIG. 5 is a cross-sectional view of a configuration example of a polarization control element and a pixel.
[FIG. 6]

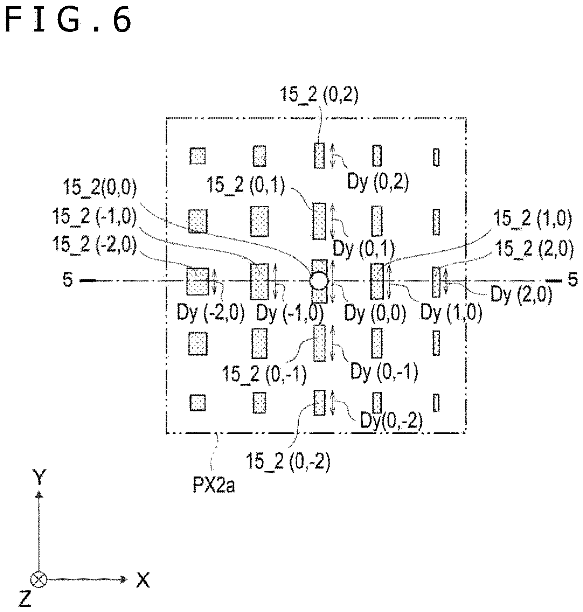

FIG. 6 is a plan view of one example of a metasurface structure of a polarization control element.
[FIG. 7]

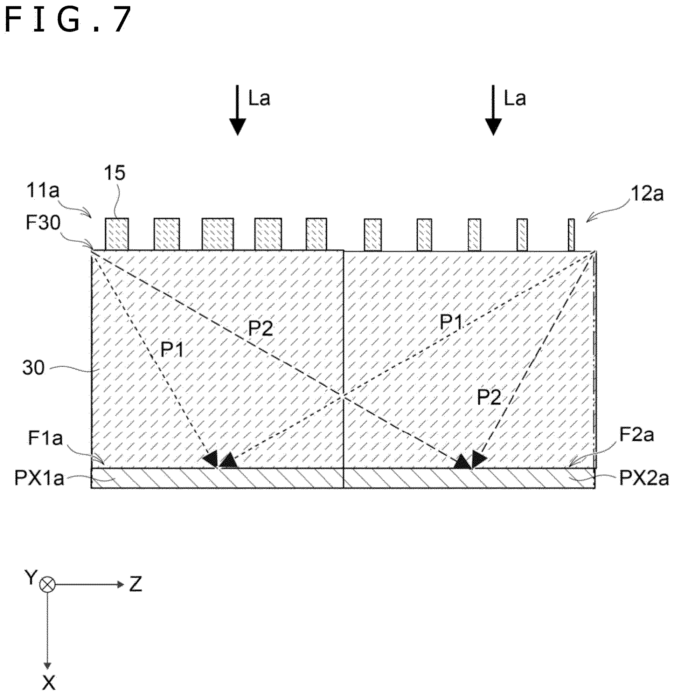

FIG. 7 is a cross-sectional view of a configuration example of polarization control elements that are adjacent to each other in an X direction.
[FIG. 8]

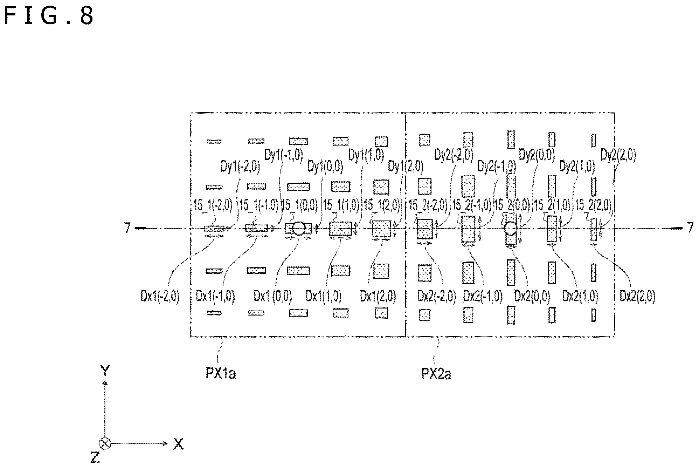

FIG. 8 is a plan view of a configuration example of polarization control elements that are adjacent to each other in the X direction.
[FIG. 9]

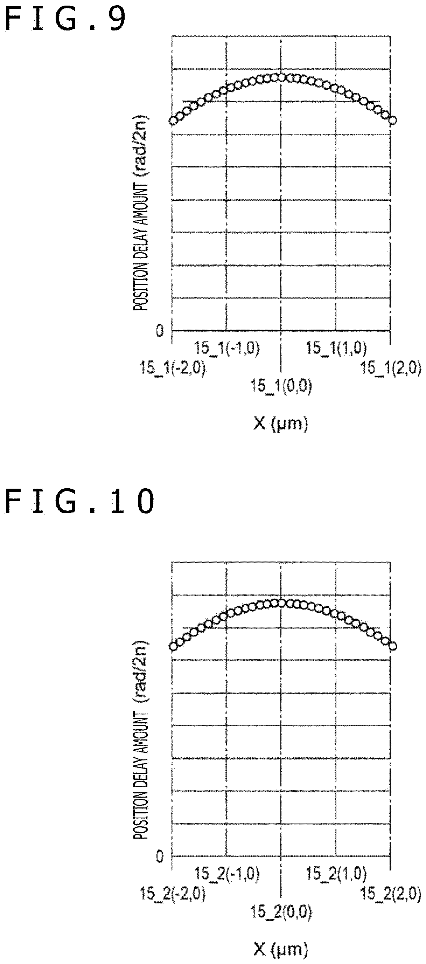

FIG. 9 is a graph indicating the relation between meta-atoms and a phase delay amount in a polarization component.
[FIG. 10]
FIG. 10 is a graph indicating the relation between meta-atoms and a phase delay amount in a polarization component.
[FIG. 11]

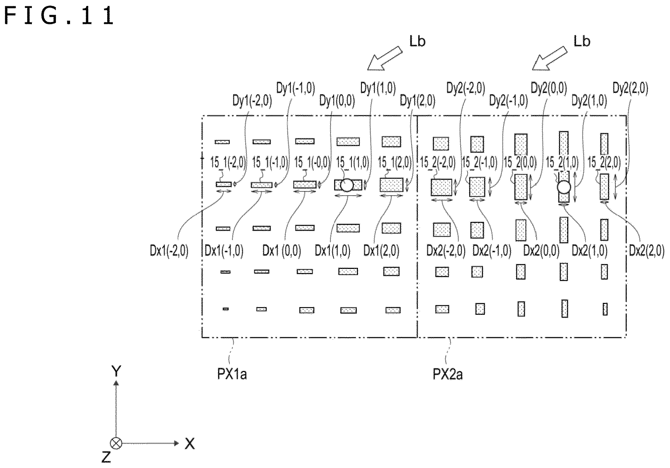

FIG. 11 is a plan view of an example of metasurface structures of polarization control elements.
[FIG. 12]

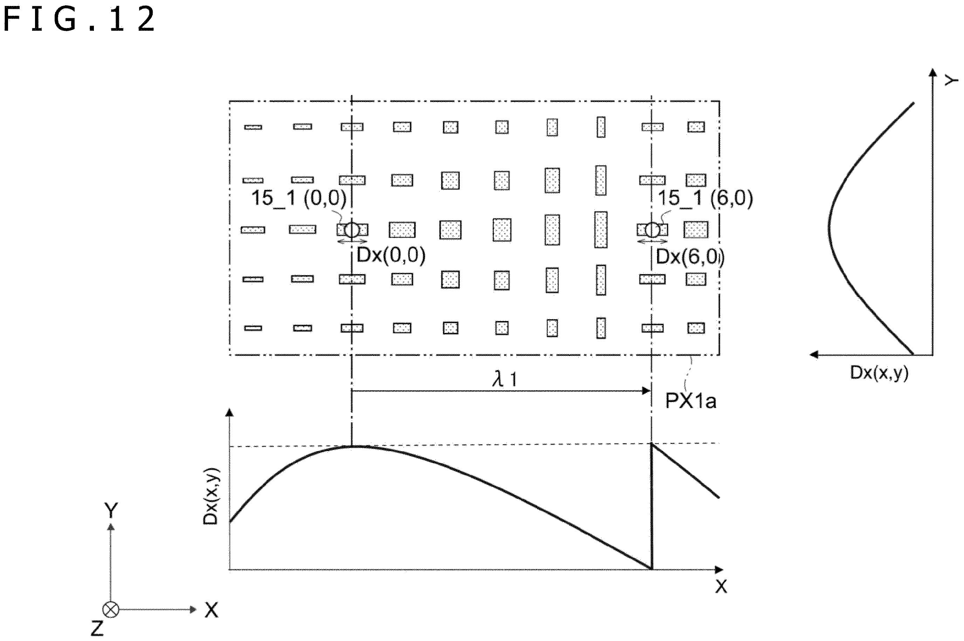

FIG. 12 is a plan view of one example of a metasurface structure of a polarization control element according to a second embodiment.
[FIG. 13]

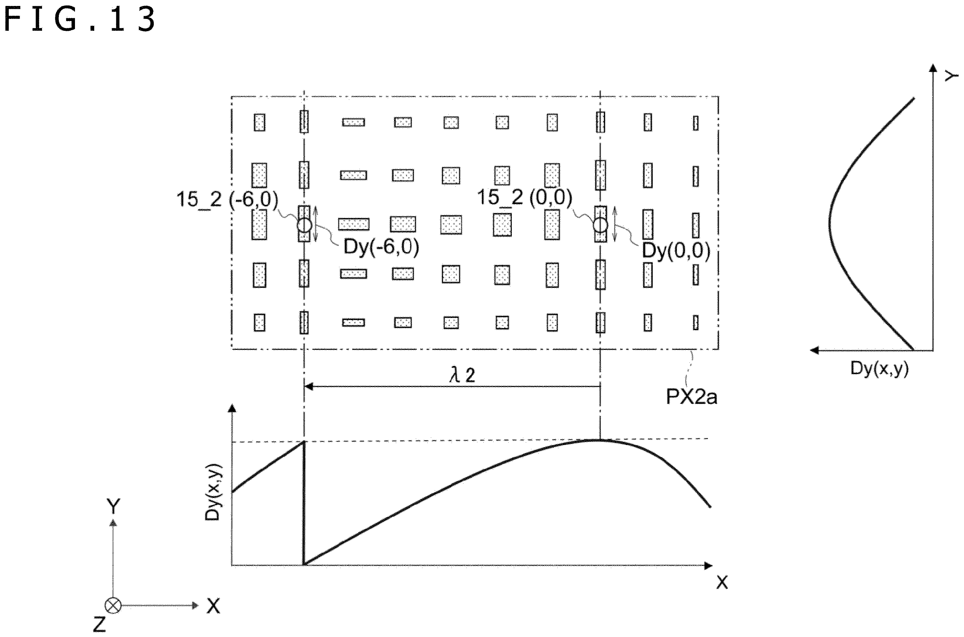

FIG. 13 is a plan view of one example of a metasurface structure of a polarization control element according to the second embodiment.
[FIG. 14A]

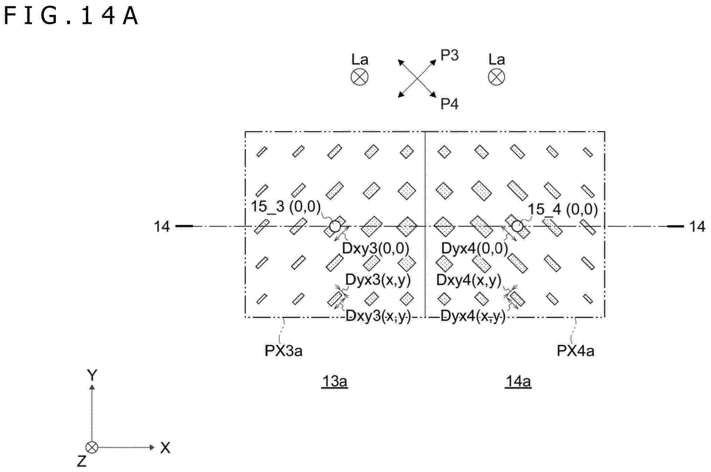

FIG. 14A is a plan view of one example of metasurface structures of polarization control elements according to a third embodiment.
[FIG. 14B]

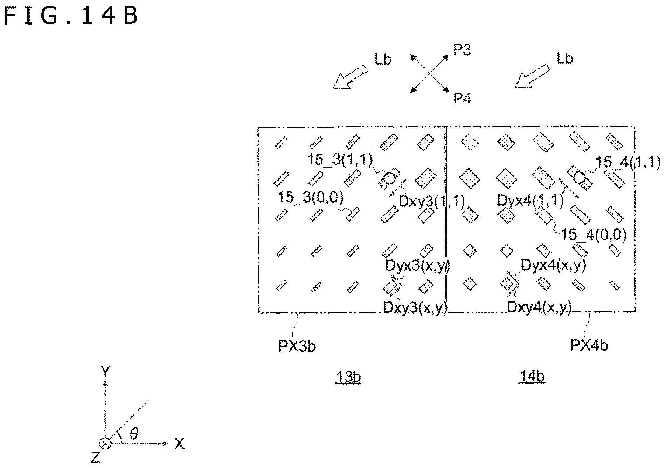

FIG. 14B is a plan view of one example of metasurface structures of polarization control elements according to the third embodiment.
[FIG. 15]

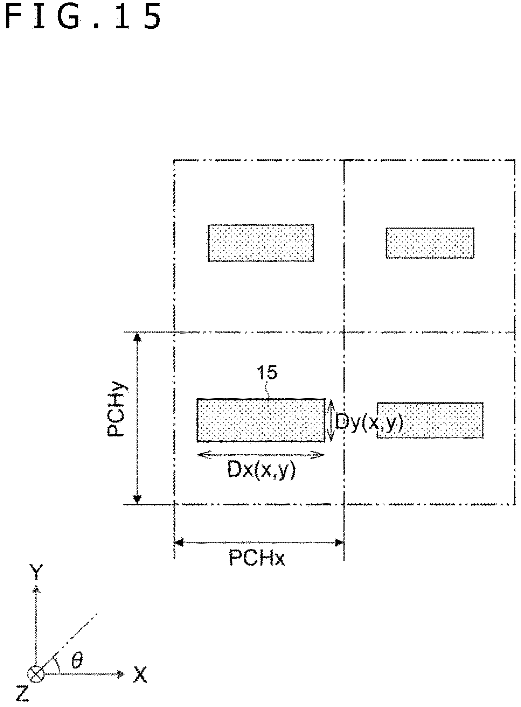

FIG. 15 is an explanatory diagram depicting the plane size of a meta-atom corresponding to a polarization component.

[FIG. 16]

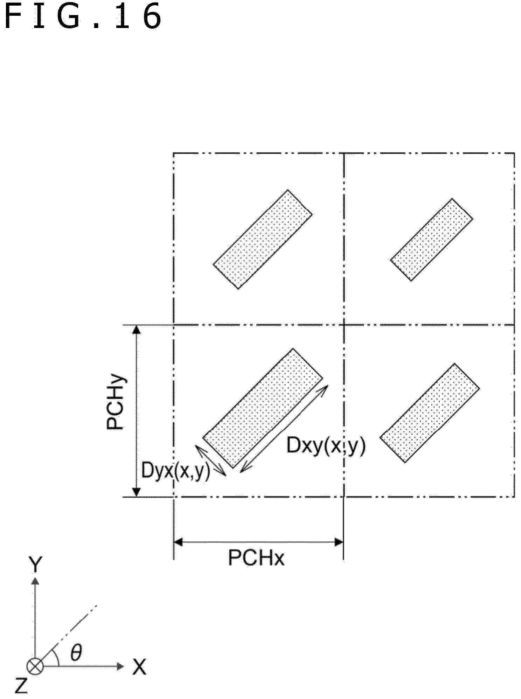

FIG. 16 is an explanatory diagram depicting the plane size of a meta-atom corresponding to a polarization component.
[FIG. 17]

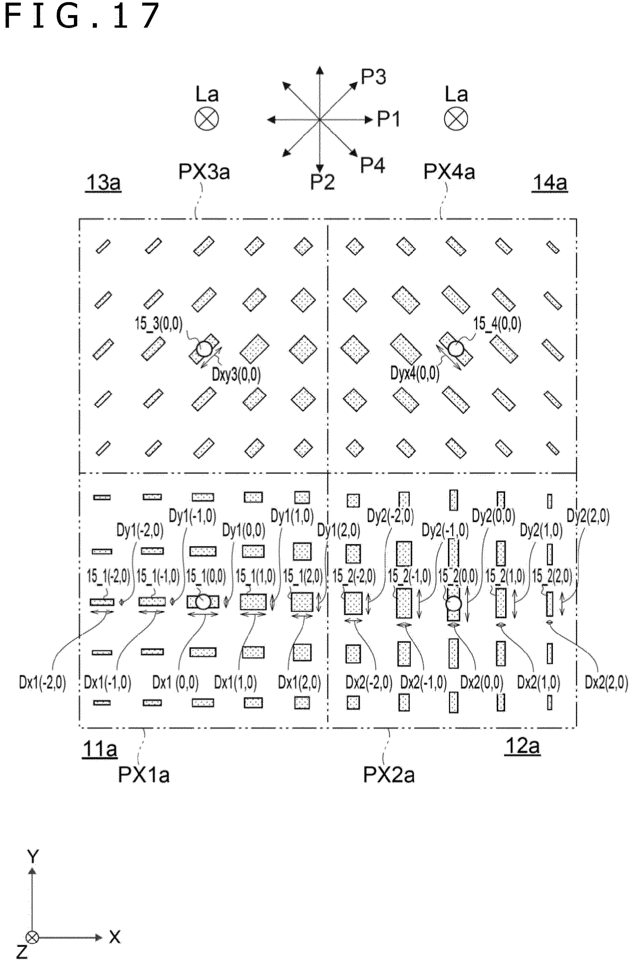

FIG. 17 is a plan view of one example of a metasurface structure of a polarization control element according to a fourth embodiment.
[FIG. 18A]

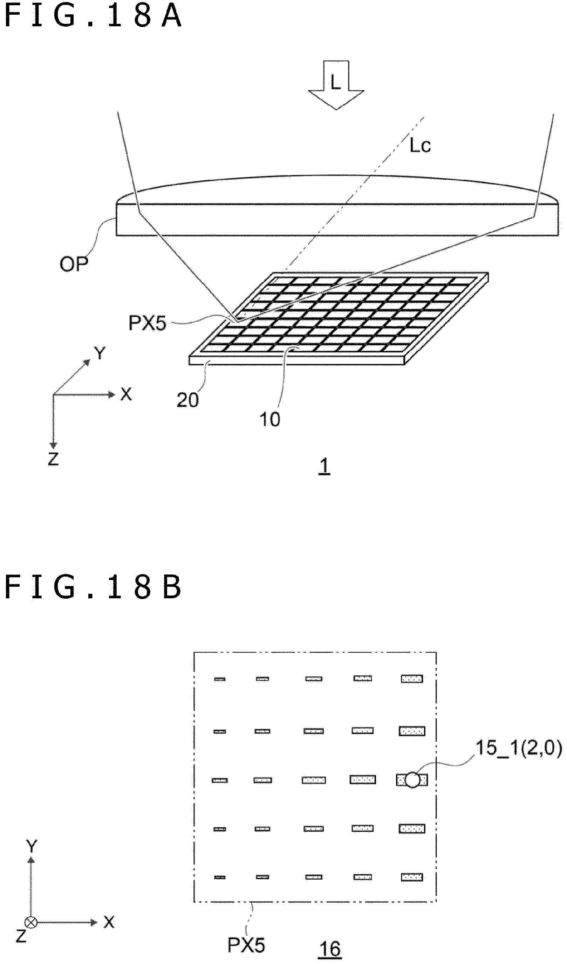

FIG. 18A is an explanatory diagram depicting the relation between the incidence angle of incident light and the position of a meta-atom having a maximum length.
[FIG. 18B]
FIG. 18B is an explanatory diagram depicting the relation between the incidence angle of incident light and the position of a meta-atom having a maximum length.
[FIG. 19A]

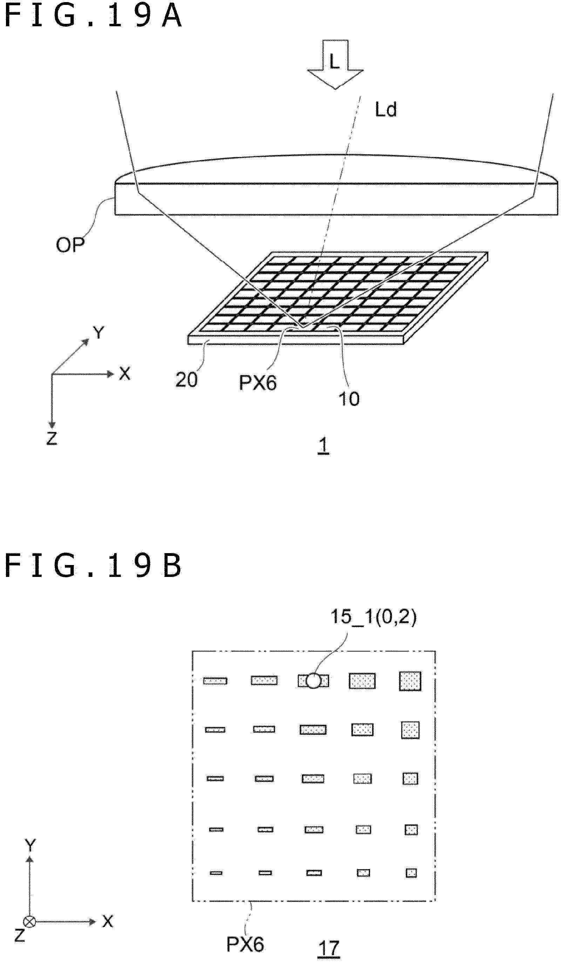

FIG. 19A is an explanatory diagram depicting the relation between the incidence angle of incident light and the position of a meta-atom having a maximum length.
[FIG. 19B]
FIG. 19B is an explanatory diagram depicting the relation between the incidence angle of incident light and the position of a meta-atom having a maximum length.
[FIG. 20A]

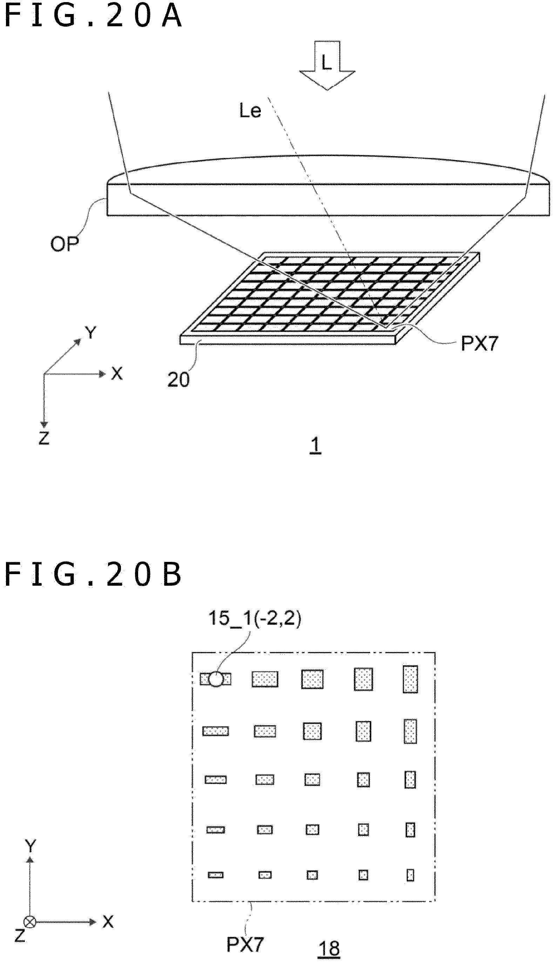

FIG. 20A is an explanatory diagram depicting the relation between the incidence angle of incident light and the position of a meta-atom having a maximum length.
[FIG. 20B]
FIG. 20B is an explanatory diagram depicting the relation between the incidence angle of incident light and the position of a meta-atom having a maximum length.
[FIG. 21]

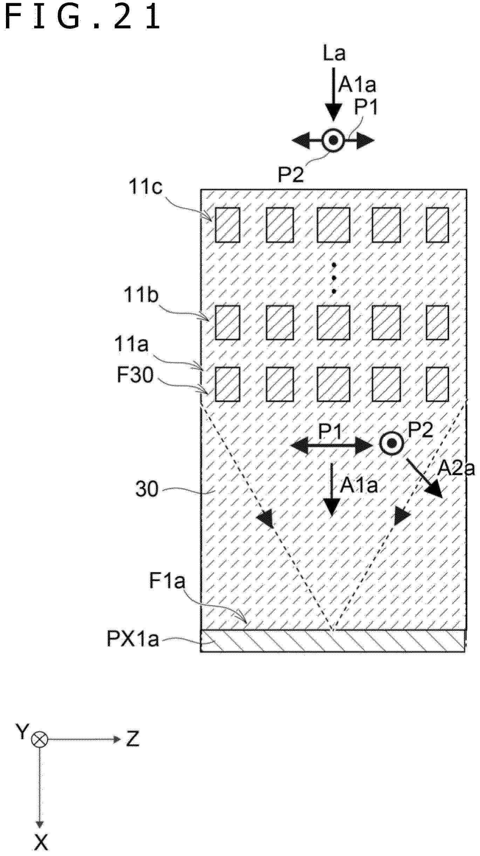

FIG. 21 is a cross-sectional view of a configuration example of a polarization control element according to a fifth embodiment.

[Description of Embodiments]

Hereinafter, specific embodiments to which the present technology is applied will be explained in detail with reference to the drawings. The drawings are schematically or conceptually made. In the drawings, the ratio of components does not necessarily match the actual one. In the description and drawings, a component that is similar to a component described with reference to an already explained drawing is denoted by the same reference sign, and a detailed explanation thereof will be omitted as appropriate.

(First Embodiment)

FIG. 1 is a schematic view of a configuration example of a solid-state imaging device 1 according to a first embodiment. The solid-state imaging device 1 may be an imaging device such as a CCD (Charge Coupled Device) image sensor or a CMOS (Complementary Metal Oxide Semiconductor) image sensor. Hereinafter, the solid-state imaging device 1 is simply referred also to as an image sensor 1.
The image sensor 1 acquires data including color information and intensity information regarding light from a subject OB which is located outside the image sensor 1, and processes the data to generate a two-dimensional image. Polarization information regarding light from the subject OB includes useful information that cannot be obtained simply from the light intensity and color (wavelength). For example, the useful information is related to the shape of a surface of the subject or the condition of the material. A technique using such polarization information as two-dimensional information is called polarization imaging. Polarization imaging is used for on-vehicle cameras, IoT devices, medical devices, etc.
The image sensor 1 includes an optical system OP, a polarization control unit 10, and a pixel region 20. The optical system OP includes a lens for condensing incident light L toward the pixel region 20. In the incident light L having passed through the optical system OP, light La enters in the optical axis direction of a principal ray while light Lb enters in a direction that is inclined with respect to the optical axis of the principal ray.
A pixel located in the center (0 image height) of the pixel region 20 receives the incident light La. A pixel located at an end (1.0 image height) of the pixel region 20 receives the incident light Lb. The polarization control unit 10 is disposed on the pixel region 20 and has a metasurface as a microstructure. A polarization control element disposed above a pixel in the center of the pixel region 20 condenses the incident light La on the pixel in the center of the pixel region 20 by performing polarization control on the incident light La. A polarization control element disposed above a pixel at an end of the pixel region 20 condenses the incident light Lb on the pixel at the end of the pixel region 20 by performing polarization control on the incident light Lb. Therefore, the polarization control unit 10 has the metasurface that can perform exit pupil correction so as to condense both the incident light La and the incident light Lb, which are different in the angles of incidence (inclination angles with respect to the optical axis of the principal ray of the incident light L), on the centers of respective pixels. The detailed configuration of the metasurface will be explained later.

FIG. 2 is a schematic view of a more detailed configuration example of the polarization control unit 10 and the pixel region 20.

The image sensor 1 includes exit pupils E1 and E2, the polarization control unit 10, and the pixel region 20. The pixel region 20 includes multiple pixels PX1a to PX2b that are two-dimensionally arranged. The pixels PX1a to PX2b each include a photodiode that performs photoelectric conversion of incident light and outputs an electrical signal. The pixels PX1a to PX2b are arranged substantially on a plane and form the pixel region 20 of a planar shape. The pixels PX1a and PX2a are located near the center (close to 0 image height) of the pixel region 20. The pixels PX1b and PX2b are located at an end (close to 1.0 image height) of the pixel region 20. The number of pixels is not limited to four, and may be three or less, or may be five or more. It is to be noted that the internal configuration of the pixels PX1a, etc. is omitted here.

The polarization control unit 10 includes polarization control elements 11a to 12b. The polarization control elements 11a to 12b are provided above (in a Z direction) an incidence surface (X-Y plane) of the pixel region 20 on which incident light is incident, and correspond to the pixels PX1a to PX2b. The polarization control elements 11a to 12b are two-dimensionally arranged in substantially parallel with the light incidence surface of the pixel region 20 and include multiple microstructures (hereinafter, also referred to as meta-atoms) on surfaces thereof. The detailed configuration of a meta-atom will be explained later.

The polarization control elements 11a and 12a correspond to the pixels PX1a and PX2a and are disposed above (in the Z direction) the pixels PX1a and PX2a, respectively. The polarization control elements 11b and 12b correspond to the pixels PX1b and PX2b and are disposed above (in the Z direction) the pixels PX1b and PX2b, respectively.

The incidence angle of incident light refers to an inclination angle with respect to the Z direction when a direction that is perpendicular to the incidence surface (X-Y plane) is defined as 0 degree. Therefore, the incident light La enters the polarization control elements 11a and 12a and the pixels PX1a and PX2a, along an arrow Aa direction at an inclination angle of 0 degree. The incident light Lb enters the polarization control elements 11b and 12b and the pixels PX1b and PX2b, along an arrow Ab direction at an inclination angle of 45 degrees, for example.

A polarization component P1 is an X-direction polarization component of the incident light La. A polarization component P2 is a Y-direction polarization component of the incident light La. The polarization component P1 is substantially orthogonal to the polarization component P2. The polarization control elements 11a and 12a condense the polarization component P1 of the incident light La on the center of the pixel PX1a, as indicated by an arrow A1a. Also, the polarization control elements 11a and 12a condense the polarization component P2 of the incident light La on the center of the pixel PX2a, as indicated by an arrow A2a. In such a manner, the polarization control elements 11a and 12a can condense the polarization components P1 and P2 on the respective centers of the two different pixels PX1a and PX2a. Accordingly, the pixels PX1a and PX2a can detect the light intensities of the polarization components P1 and P2, respectively.

On the other hand, the incident light Lb enters the polarization control elements 11b and 12b along a direction indicated by an arrow Ab which is inclined from the Z direction. Therefore, a polarization component P3 is a polarization component of the incident light Lb in a direction that is inclined by 45 degrees from the X direction, and a polarization component P4 is a Y-direction polarization component of the incident light Lb. The polarization component P3 is substantially orthogonal to the polarization component P4. The polarization control elements 11b and 12b convert the polarization component P3 to an X-direction polarization component to be condensed on the center of the pixel PX1b, as indicated by an arrow A1b. Also, the polarization control elements 11b and 12b condense the polarization component P4 of the incident light Lb on the center of the pixel PX2b, as indicated by an arrow A2b. In such a manner, the polarization control elements 11b and 12b can condense the polarization components P3 and P4 of the incident light Lb on the respective centers of the two different pixels PX1b and PX2b. Accordingly, the pixels PX1b and PX2b can detect the light intensities of the polarization components P3 and P4, respectively. In addition, the incident light Lb is incident in a direction inclined from the optical axis direction (Z direction) of the incident light L, but the polarization control elements 11b and 12b correct the direction of the incident light Lb (exit pupil correction) to be condensed on the centers of the pixels PX1b and PX2b.

(Pixel that is located near the center (0 image height) of the pixel region 20)

FIG. 3 is a cross-sectional view of a configuration example of the polarization control element 11a and the pixel PX1a. A waveguide 30 is provided on one pixel PX1a. For example, a transparent material which is any one of amorphous silicon, polycrystalline silicon, germanium, titanium oxide, niobium oxide, tantalum oxide, aluminum oxide, hafnium oxide, silicon nitride, silicon oxide, silicon nitride oxide, silicon carbide, silicon oxide carbide, silicon nitride carbide, or zirconium oxide is used for the waveguide 30.

The polarization control element 11a is disposed on the waveguide 30. The polarization control element 11a has a metasurface structure and includes multiple meta-atoms 15 as multiple microstructures. The multiple meta-atoms 15 are disposed above an incidence surface F1a of the pixel PX1a on which the incident light La is incident, and are two-dimensionally arranged into a substantially flat surface shape on an upper surface F30 of the waveguide 30. The upper surface F30 of the waveguide 30 is substantially parallel with the incidence surface F1a of the pixel PX1a. For example, a transparent material which is any one of amorphous silicon, polycrystalline silicon, germanium, titanium oxide, niobium oxide, tantalum oxide, aluminum oxide, hafnium oxide, silicon nitride, silicon oxide, silicon nitride oxide, silicon carbide, silicon oxide carbide, silicon nitride carbide, or zirconium oxide is used for each of the multiple meta-atoms 15. However, a material that is used for the meta-atoms 15 is different from the material of the waveguide 30. For example, in a case where a silicone oxide film or titanium oxide is used for the waveguide 30, for example, a silicon single crystal or amorphous silicon is used for the meta-atoms 15.

The metasurface structure of the polarization control element 11a condenses the polarization component P1 of the incident light La on the center of the pixel PX1a, as indicated by the arrow A1a. Further, the metasurface structure of the polarization control element 11a is configured to condense the polarization component P2 on the center of the pixel PX1b, as indicated by the arrow A2a. It is to be noted that the pixel PX1b, which is not depicted in FIG. 3, is disposed to be adjacent to the pixel PX1a in the X direction.

FIG. 4 is a plan view of one example of the metasurface structure of the polarization control element 11a. Above the incidence surface F1a of the pixel PX1a, the multiple meta-atoms 15 of the polarization control element 11a are two-dimensionally arranged in a matrix form substantially parallel with the incidence surface F1a. It is to be noted that a cross section taken along line 3-3 in FIG. 4 corresponds to FIG. 3.

A meta-atom 15_1 (0, 0) is disposed in the center of the pixel PX1a. (x, y) (x and y are integers) represents coordinates in the pixel PX1a on the X-Y plane. It is to be noted that the multiple meta-atoms 15 may all have the same height in the Z direction.

Here, the length Dx (x, y) of the meta-atom 15_1 (x, y) in the polarization direction (X direction) of the polarization component P1 will be explained. In the pixel PX1a which is near the center of the pixel region 20, the length Dx (0, 0) of the meta-atom 15_1 (0, 0) in the X direction is the longest of the lengths of the multiple meta-atoms 15 (x, y) corresponding to the pixel PX1a. That is, of the multiple meta-atoms 15_1 (x, y) corresponding to the pixel PX1a, the meta-atom 15_1 (0, 0), which is a first microstructure having a maximum length in the polarization direction of the polarization component P1, is located in the center of the pixel PX1a.

The two meta-atoms 15_1 (±1, 0) which are adjacent to the meta-atom 15_1 (0, 0) in the ±X direction have, in the polarization direction (X direction), respective lengths Dx (±1, 0) that are shorter than the length Dx (0, 0) of the meta-atom 15_1 (0, 0). Furthermore, the two meta-atoms 15_1 (±2, 0) which are adjacent to the meta-atoms 15_1 (±1, 0) in the ±X direction have, in the X direction, respective lengths Dx (±2, 0) that are further shorter than the lengths Dx (±1, 0) of the meta-atoms 15_1 (±1, 0).

In addition, the two meta-atoms 15_1 (0, ±1) which are adjacent to the meta-atom 15_1 (0, 0) in the ±Y direction have, in the polarization direction (X direction), respective lengths Dx (0, ±1) that are shorter than the length Dx (0, 0) of the meta-atom 15_1 (0, 0). Furthermore, the two meta-atoms 15_1 (0, ±2) which are adjacent to the meta-atoms 15_1 (0, ±1) in the ±Y direction have, in the X direction, respective lengths Dx (±2, 0) that are further shorter than the lengths Dx (0, ±1) of the meta-atoms 15_1 (0, ±1).

Therefore, in the pixel PX1a which is near the center of the pixel region 20, the length Dx (0, 0), in the polarization direction, of the meta-atom 15_1 (0, 0) which is near the center of the pixel PX1a is maximum, and the length Dx (x, y) in the polarization direction becomes shorter with an increase of the distance from the center of the pixel PX1a.

With the length Dx (x, y) of the meta-atom 15_1 (x, y) in the polarization direction of the polarization component P1, a phase delay distribution of the polarization component P1 is adjusted. For example, the length Dx (0, 0), in the polarization direction, of the meta-atom 15_1 (0, 0) which is near the center of the pixel PX1a is set to be maximum, as explained above, so that a peak of the phase delay distribution of the polarization component P1 appears in a position near the center of the pixel PX1a. Furthermore, the length Dx (x, y) is set to gradually become shorter with an increase of the distance from the center of the pixel PX1a, so that a phase delay amount of the polarization component P1 gradually becomes smaller with an increase of the distance from the center of the pixel PX1a.

FIG. 5 is a cross-sectional view of a configuration example of the polarization control element 12a and the pixel PX2a. The waveguide 30 is provided also on one pixel PX2a, in a manner similar to that in the pixel PX1a.

The polarization control element 12a is disposed on the waveguide 30. The polarization control element 12a has a metasurface structure and includes multiple meta-atoms 15 as multiple microstructures. The multiple meta-atoms 15 are disposed above an incidence surface F2a of the pixel PX2a on which of the incident light La is incident, and are two-dimensionally arranged into a substantially flat surface shape on the upper surface F30 of the waveguide 30.

The metasurface structure of the polarization control element 12a condenses the polarization component P2 of the incident light La on the center of the pixel PX2a, as indicated by the arrow A2a. Further, the metasurface structure of the polarization control element 12a is configured to condense the polarization component P1 on the center of the pixel PX1a (FIG. 3) which is adjacent to the pixel PX2a in the -X direction, as indicated by the arrow A1a.

FIG. 6 is a plan view of one example of the metasurface structure of the polarization control element 12a. Above the incidence surface F2a of the pixel PX2a, the multiple meta-atoms 15 of the polarization control element 12a are two-dimensionally arranged in a matrix form substantially parallel with the incidence surface F2a. It is to be noted that a cross section taken along line 5-5 in FIG. 6 corresponds to FIG. 5.

A meta-atom 15_2 (0, 0) is disposed in the center of the pixel PX2a. (x, y) (x and y are integers) represents coordinates in the pixel PX2a on the X-Y plane. It is to be noted that the multiple meta-atoms 15 may all have the same height in the Z direction.

Here, the length Dy (x, y) of the meta-atom 15_2 (x, y) in the polarization direction (Y direction) of the polarization component P2 will be explained. In the pixel PX2a which is near the center of the pixel region 20, the length Dy (0, 0), in the Y direction, of the meta-atom 15_2 (0, 0) which is near the center of the pixel PX2a is the longest of the lengths of the multiple meta-atoms 15_2 (x, y) corresponding to the pixel PX2a. That is, of the multiple meta-atoms 15_2 (x, y) corresponding to the pixel PX2a, the meta-atom 15_2 (0, 0), which is a second microstructure having a maximum length in the polarization direction (Y direction) of the polarization component P2, is located in the center of the pixel PX2a.

The two meta-atoms 15_2 ($\pm$1, 0) which are adjacent to the meta-atom 15_2 (0, 0) in the $\pm$X direction have, in the polarization direction (Y direction), respective lengths Dy ($\pm$1, 0) that are shorter than the length Dy (0, 0) of the meta-atom 15_2 (0, 0) in the Y direction. Furthermore, the two meta-atoms 15_2 ($\pm$2, 0) which are adjacent to the meta-atoms 15_2 ($\pm$1, 0) in the $\pm$X direction have, in the Y direction, respective lengths Dy ($\pm$2, 0) that are further shorter than the lengths Dy ($\pm$1, 0) of the meta-atoms 15_2 ($\pm$1, 0) in the Y direction.

In addition, the two meta-atoms 15_2 (0, $\pm$1) which are adjacent to the meta-atom 15_2 (0, 0) in the $\pm$Y direction have, in the polarization direction (Y direction), respective lengths Dy (0, $\pm$1) that are shorter than the length Dy (0, 0) of the meta-atom 15_2 (0, 0) in the Y direction. Furthermore, the two meta-atoms 15_2 (0, $\pm$2) which are adjacent to the meta-atoms 15_2 (0, $\pm$1) in the $\pm$Y direction have, in the Y direction, respective lengths Dy ($\pm$2, 0) that are further shorter than the lengths Dy (0, $\pm$1) of the meta-atoms 15_2 (0, $\pm$1) in the Y direction.

Therefore, in the pixel PX2a which is near the center of the pixel region 20, the length Dy (0, 0), in the polarization direction of the polarization component P2, of the meta-atom 15_2 (0, 0) which is near the center of the pixel PX2a is maximum, and the length Dy (x, y) in the polarization direction of the polarization component P2 gradually becomes shorter with an increase of the distance from the center of the pixel PX2a.

Therefore, in the pixel PX2a which is near the center of the pixel region 20, the length Dy (0, 0), in the polarization direction, of the meta-atom 15_2 (0, 0) which is near the center of the pixel PX2a is maximum, and the length Dy (x, y) in the polarization direction gradually becomes shorter with an increase of the distance from the center of the pixel PX2a.

With the length Dy (x, y) of the meta-atom 15_2 (x, y) in the polarization direction (Y direction) of the polarization component P2, a phase delay distribution of the polarization component P2 is adjusted. For example, the length Dy (0, 0), in the polarization direction, of the meta-atom 15_2 (0, 0) which is near the center of the pixel PX2a is set to be maximum, as explained above, so that a peak of the phase delay distribution in the polarization component P2 appears in a position near the center of the pixel PX2a. Furthermore, the length Dy (x, y) is set to gradually become shorter with an increase of the distance from the center of the pixel PX2a, so that a phase delay amount of the polarization component P2 gradually becomes smaller with an increase of the distance from the center of the pixel PX2a.

The polarization control elements 11a and 12a each have a metasurface structure so as to be able to perform exit pupil correction on the polarization control elements P1 and P2 continuously in the X direction.

For example, FIG. 7 is a cross-sectional view of a configuration example of the polarization control elements 11a and 12a that are adjacent to each other in the X direction. FIG. 8 is a cross-sectional view of a configuration example of the polarization control elements 11a and 12a that are adjacent to each other in the X direction. FIG. 7 corresponds to a cross section taken along line 7-7 in FIG. 8. It is to be noted that the lengths Dx (x, y) in the pixels PX1a and PX1a are denoted by Dx1 (x, y) and Dx2 (x, y), respectively, for convenience in differentiating. Also, the lengths Dy (x, y) in the pixels PX1a and PX1a are denoted by Dy1 (x, y) and Dy2 (x, y), respectively, for convenience in differentiating.

In the polarization direction (X direction) of the polarization component P1, the length of the meta-atom 15_1 (x, y) of the polarization control element 11a is maximum at the meta-atom 15_1 (0, 0) and becomes shorter with an increase of the distance from the meta-atoms 15_1 (0, 0), as previously explained. This tendency continues also in the polarization control element 12a. That is, in the polarization control element 12a, the length of the meta-atom 15_2 (x, y) in the polarization direction of the polarization component P1 becomes gradually shorter from Dx2 (-2, 0) of the meta-atom 15_2 (-2, 0) which is relatively close to the meta-atom 15_1 (0, 0), to Dx2 (2, 0) of the meta-atom 15_2 (2, 0) which is relatively far from the meta-atom 15_1 (0, 0). Accordingly, the two adjacent polarization control elements 11a and 12a can condense the polarization component P1 on the pixel PX1a, as depicted in FIG. 7.

Also, in the polarization direction (Y direction) of the polarization component P2, the length of the meta-atom 15_2 (x, y) is maximum at the meta-atom 15_2 (0, 0) and becomes shorter with an increase of the distance from the meta-atom 15_2 (0, 0), as previously explained. This tendency continues also in the polarization control element 11a. That is, in the polarization control element 11a, the length of the meta-atom 15_1 (x, y) in the polarization direction of the polarization component P2 becomes gradually shorter from Dy1 (2, 0) of the meta-atom 15_1 (2, 0) which is relatively close to the meta-atom 15_2 (0, 0) to Dy2 (-2, 0) of the meta-atom 15_1 (-2, 0) which is relatively far from the meta-atom 15_2 (0, 0). Accordingly, the two adjacent polarization control elements 11a and 12a can condense the polarization component P2 on the pixel PX2a, as depicted in FIG. 7.

According to the present disclosure, as explained so far, the lengths of the meta-atom 15_1 (x, y) and the meta-atom 15_2 (x, y) in the pixel PX1 and PX2 in the polarization direction (X direction) of the polarization component P1 become shorter with an increase of the distance from the meta-atom 15_1 (0, 0) which has a maximum length. As a result, the phase delay distribution of the polarization component P1 has a maximum value at the meta-atom 15_1 (0, 0) located in the center of the pixel PX1a, and the value thereof becomes smaller with an increase of the distance from the meta-atom 15_1 (0, 0). FIG. 9 is a graph indicating the relation between the meta-atom 15_1 (x, y) and the phase delay amount of the polarization component P1, for example. According to this graph, the phase delay amount of the polarization component P1 is maximum at the meta-atom 15_1 (0, 0) and decreases with an increase of the distance from the meta-atom 15_1 (0, 0). Therefore, with the metasurface structure according to the present disclosure, the polarization component P1 of the incident light La can be condensed on the center of the pixel PX1a. It is to be noted that FIG. 9 indicates the tendency of meta-atoms that are arranged in the X direction, but the phase delay distribution of the polarization component P1 has the similar tendency also in meta-atoms that are arranged in the Y direction.

Furthermore, the lengths of the multiple meta-atoms 15_1 (x, y) and 15_2 (x, y) in the pixel PX1 and PX2 in the polarization direction of the polarization component P2 become shorter with an increase of the distance from the meta-atom 15_2 (0, 0) which has a maximum length. As a result, the phase delay distribution of the polarization component P2 has a maximum value at the meta-atom 15_2 (0, 0) located in the center of the pixel PX2a, and the value thereof becomes smaller with an increase of the distance from the meta-atom 15_2 (0, 0). FIG. 10 is a graph indicating the relation between the meta-atom 15_2 (x, y) and the phase delay amount of the polarization component P2, for example. According to this graph, the phase delay amount of the polarization component P2 is maximum at the meta-atom 15_2 (0, 0). The phase delay amount of the polarization component P2 decreases with an increase of the distance from the meta-atom 15_2 (0, 0). Therefore, with the metasurface structure according to the present disclosure, the polarization component P2 of the incident light La can be condensed on the center of the pixel PX2a. It is to be noted that FIG. 10 indicates the tendency of meta-atoms that are arranged in the X direction, but the phase delay distribution of the polarization component P1 has the similar tendency also in meta-atoms that are arranged in the Y direction.

(Pixel that is located near an end (1.0 image height) of the pixel region 20)

FIG. 11 is a plan view of an example of the metasurface structures of the polarization control elements 11b and 12b. It is to be noted that illustration of a cross section of the polarization control elements 11b and 12b is omitted.

The polarization control elements 11b and 12b correspond to the pixels PX1b and PX2b which are located at an end (1.0 image height) of the pixel region 20, respectively. Therefore, the incident light Lb is incident from a direction that is inclined from the optical axis (Z axis) of the principal ray of the incident light L. The angle of incidence of the incident light Lb is 45 degrees, for example. The polarization control elements 11b and 12b have respective metasurface structures for condensing polarization components P3 and P4 of the incident light Lb (hereinafter, also referred to as inclined light Lb) that is inclined with respect to the Z axis, on the pixels PX1b and PX2b.

Here, the lengths Dx1 (x, y) and Dx2 (x, y) of the meta-atoms 15_1 (x, y) and 15_2 (x, y) in the polarization direction (X direction) of the polarization component P3 of the inclined light Lb, will be explained. The length Dx1 (1, 1), in the X direction, of the meta-atom 15_1 (1, 1) which is distant from the center of the pixel PX1b is the longest of the lengths of multiple meta-atoms 15_1 (x, y) and 15_2 (x, y) corresponding to the pixels PX1b and PX2b. That is, of the multiple meta-atoms 15_1 (x, y) and 15_2 (x, y) corresponding to the pixels PX1b and PX2b, the meta-atom 15_1 (1, 1), which is a first microstructure having a maximum length in the polarization direction of the polarization component P3, is located in a position deviated from the center of the pixel PX1b. This is because the polarization component P3 is to be condensed on the center of the pixel PX1b through exit pupil correction of the inclined light Lb. In the present disclosure, the inclined light Lb is incident from a direction that is inclined from the +X axis and +Y axis. In this case, a meta-atom having a maximum length is set in a position that is shifted (offset) from the center of the pixel PX1b in the inclination direction of the inclined light Lb, or in the +X direction and +Y direction. The shift amount of the meta-atom having the maximum length from the center of the pixel PX1b (offset amount from the center of the pixel PX1b) depends on the distance from the center of the pixel region 20 to the pixel PX1b and increases with an increase of the distance. In other words, the shift amount of the meta-atom having the maximum length depends on the inclination angle of the inclined light Lb and increases with an increase of the inclination angle. For example, since the pixel PX1b in the present disclosure is located near an end (1.0 image height) of the pixel region 20, the meta-atom 15_1 (1, 1) which is shifted in the +X direction and +Y direction from the center of the corresponding pixel PX1b by a predetermined distance is determined as a meta-atom having a maximum length. It is to be noted that the offset amount can be optionally determined. Therefore, the endmost meta-atom 15_2 (2, 2) may be defined as a meta-atom having a maximum length, as depicted in FIGS. 18A to 20B.

The two meta-atoms 15_1 (0, 1) and 15_1 (2, 1) which are adjacent to the meta-atom 15_1 (1, 1) in the $\pm$X direction have, in the polarization direction (X direction), respective lengths Dx (0, 1) and Dx (2, 1) that are shorter than the length Dx (1, 1) of the meta-atom 15_1 (1, 1). Furthermore, the two meta-atoms 15_1 (-1, 1) and 15_2 (-2, 1) which are adjacent to the meta-atoms 15_1 (0, 1) and 15_1 (2, 1) in the $\pm$X direction have, in the X direction, respective lengths Dx (-1, 1) and Dx (-2, 1) that are further shorter than the lengths Dx1 (0, 1) and Dx1 (2, 1) of the meta-atoms 15_1 (0,1) and 15_1 (2, 1).

In addition, the two meta-atoms 15_1 (1, 2) and 15_1 (1, 0) which are adjacent to the meta-atom 15_1 (1, 1) in the $\pm$Y direction have, in the polarization direction (X direction), respective lengths Dx1 (1, 2) and Dx1 (1, 0) that are shorter than the length Dx1 (1, 1) of the meta-atom 15_1 (1, 1). Furthermore, the meta-atom 15 1 (1, -1) which is adjacent to the meta-atoms 15_1 (1, 0) in the -Y direction has, in the X direction, a length Dx1 (1, -1) that is further shorter than the length Dx1 (1, 0) of the meta-atom 15_1 (1, 0).

Next, the lengths Dy1 (x, y) and Dy2 (x, y) of the meta-atoms 15_1 (x, y) and 15_2 (x, y) in the polarization direction (Y direction) of the polarization component P4 of the inclined light Lb, will be explained. The length Dy2 (1, 1), in the Y direction, of the meta-atom 15_2 (1, 1) which is distant from the center of the pixel PX2b is the longest of the lengths of multiple meta-atoms 15_1 (x, y) and 15_2 (x, y) corresponding to the pixels PX1b and PX2b. That is, of the multiple meta-atoms 15_1 (x, y) and 15_2 (x, y) corresponding to the pixels PX1b and PX2b, the meta-atom 15_2 (1, 1), which is a second microstructure having a maximum length in the polarization direction of the polarization component P4, is located in a position deviated from the center of the pixel PX2b. This is because the polarization component P4 is to be condensed on the center of the pixel PX2b through exit pupil correction of the inclined light Lb. In the present disclosure, the inclined light Lb is incident from a direction that is inclined from the +X axis and +Y axis. In this case, a meta-atom having a maximum length is set in a position that is shifted (offset) from the center of the pixel PX2b in the inclination direction of the inclined light Lb, or in the +X direction and +Y direction. The shift amount of the meta-atom having a maximum length from the center of the pixel PX2b (offset amount from the center of the pixel PX2b) depends on the distance from the center of the pixel region 20 to the pixel PX2b and increases with an increase of the distance. In other words, the shift amount of the meta-atom having the maximum length depends on the inclination angle of the inclined light Lb and increases with an increase of the inclination angle. For example, since the pixel PX2b in the present disclosure is located near an end (1.0 image height) of the pixel region 20, the meta-atom 15_2 (1, 1) which is shifted in the +X direction and +Y direction from the center of the pixel PX2b by a predetermined distance is determined as a meta-atom having the maximum length. It is to be noted that the offset amount can be optionally determined. Therefore, the endmost meta-atom 15_2 (2, 2) may be defined as a meta-atom having a maximum length, as depicted in FIGS. 18A to 20B.

The two meta-atoms 15_2 (0, 1) and 15_2 (2, 1) which are adjacent to the meta-atom 15_2 (1, 1) in the $\pm$X direction have, in the polarization direction (Y direction), respective lengths Dy (0, 1) and Dy (2, 1) that are shorter than the length Dy2 (1, 1) of the meta-atom 15_2 (1, 1). Furthermore, the meta-atom 15_2 (-1, 1) which is adjacent to the meta-atom 15_2 (0, 1) in the -X direction has, in the Y direction, a length Dy2 (-1, 1) that is further shorter than the length Dy2 (0, 1) of the meta-atom 15_2 (0, 1).

In addition, the two meta-atoms 15_2 (1, 2) and 15_2 (1, 0) which are adjacent to the meta-atom 15_2 (1, 1) in the $\pm$Y direction have, in the polarization direction (Y direction), respective lengths Dy2 (1, 2) and Dy2 (1, 0) that are shorter than the length Dy2 (1, 1) of the meta-atom 15_1 (1, 1). Furthermore, the meta-atom 15_1 (1, -1) which is adjacent to the meta-atom 15_1 (1, 0) in the -Y direction has, in the X direction, a length Dy2 (1, -1) that is further shorter than the length Dy2 (1, 0) of the meta-atom 15_1 (1, 0).

Therefore, in the pixel PX1b which is near an end (1.0 image height) of the pixel region 20, a meta-atom that is shifted from the center of the PX1b by a prescribed offset amount has a maximum length according to the inclination amount of the inclined light Lb. For example, the meta-atom 15_1 (1, 1) has the maximum length Dx1 (1, 1) in the polarization direction (X direction) of the polarization component P3, and the length in the polarization direction (X direction) gradually becomes shorter with an increase of the distance from the meta-atom 15_1 (1, 1) having the maximum length. In addition, the meta-atom 15_2 (1, 1) which is shifted from the center of the pixel PX2b by a prescribed offset amount has the maximum length Dy2 (1, 1) in the polarization direction (Y direction) of the polarization component P4. Further, the length in the polarization direction (Y direction) becomes gradually shorter with an increase of the distance from the meta-atom 15_2 (1, 1) having the maximum length.

As explained so far, the position, in each pixel, of a meta-atom having a maximum length in the each of the polarization directions of the polarization components P1 to P4 of the incident light La and the incident light Lb, depends on the distance from the center of the pixel region 20 to the corresponding pixel. For example, in the pixels PX1a and PX2a which are substantially in the center of the pixel region 20, the meta-atom 15_1 (0, 0) or 15 2 (0, 0) having a maximum length in the polarization direction of the polarization components P1 and P2 is located substantially in the center of the pixel PX1a or PX2a.

On the other hand, in the pixels PX1b and PX2b which are near an end of the pixel region 20, the meta-atom 15_1 (1, 1) or 15_2 (1, 1) having a maximum length in the polarization direction of the polarization components P3 and P4 is shifted (offset) from the center of the pixel PX1b or PX2b by a prescribed distance. Accordingly, the polarization control elements 11b and 12b can perform exit pupil correction on the inclined light Lb and can condense the polarization components P3 and P4 on the centers of the pixels PX1b and PX2b, respectively.

The distance between the meta-atom 15_1 (1, 1) or 15_2 (1, 1) having a maximum length and the center of the pixel PX1b or PX2b depends on the distance from the center of the pixel region 20 to the pixel PX1b or PX2b. For example, the distance from the position of the meta-atom 15_1 (1, 1) or 15_2 (1, 1) having a maximum length to the center of the pixel PX1b or PX2b increases with an increase of the distance from the center of the pixel region 20 to the pixel PX1b or PX2b. That is, the distance from the position of the meta-atom 15_1 (1, 1) or 15_2 (1, 1) having a maximum length to the center of the pixel PX1b or PX2b increases with an increase of the inclination angle of the inclined light Lb. Accordingly, the polarization control elements 11a to 12b can perform exit pupil correction on the incident light La and the incident light Lb each having an given inclination angle and can condense the polarization components P1 to P4 on the centers of the desired pixels PX1a to PX2b.

(Second Embodiment)

FIG. 12 is a plan view of one example of the metasurface structure of the polarization control element 11a according to a second embodiment. FIG. 12 further indicates a graph of the length Dx (x, y) of the meta-atom 15_1 (x, y) in the polarization direction of the polarization component P1.

In the second embodiment, the length of meta-atoms in the polarization direction (X direction) of the polarization component P1 is restored at every given distance (for example, a substantial wavelength $\lambda 1$ of the polarization component P1) from the longest meta-atom 15_1 (0, 0). For example, in FIG. 12, the length Dx (6, 0) of the meta-atom 15_1 (6, 0), which is at an given distance from the meta-atom 15_1 (0, 0) having a maximum length, is substantially equal to the length Dx (0, 0) of the meta-atom 15_1 (0, 0). In such a manner, the length of the meta-atom 15_1 (x, y) may be cyclically restored to be equal to the length Dx (0, 0) of the meta-atom 15_1 (0, 0) at every given distance. Accordingly, even in a case where the plane size of the pixel PX1a is greater than the wavelength of the polarization component P1, exit pupil correction can be performed.

FIG. 13 is a plan view of one example of the metasurface structure of the polarization control element 12a according to the second embodiment. FIG. 13 further indicates a graph of the length Dy (x, y) of the meta-atom 15_2 (x, y) in the polarization direction of the polarization component P2.

Also, in the polarization direction (Y direction) of the polarization component P2, the length of a meta-atom is restored at every given distance (for example, a substantial wavelength $\lambda 2$ of the polarization component P2) from the meta-atom 15_2 (0, 0) having a maximum length. For example, in FIG. 13, the length Dy (-6, 0) of the meta-atom 15_2 (-6, 0), which is at an given distance from the meta-atom 15_2 (0, 0) having a maximum length, is substantially equal to the length Dy (0, 0) of the meta-atom 15_2 (0, 0). In such a manner, the length of the meta-atom 15_2 (x, y) may be cyclically restored to be equal to the length Dy (0, 0) of the meta-atom 15_2 (0, 0) at every given distance. Accordingly, even in a case where the plane size of the pixel PX2a is greater than the wavelength of the polarization component P2, exit pupil correction can be performed.

The remaining configurations of the second embodiment may be identical to those of the first embodiment. Accordingly, the second embodiment can provide the effect similar to that of the first embodiment.

(Third Embodiment)

FIG. 14A is a plan view of one example of the metasurface structures of polarization control elements 13a and 14a according to a third embodiment. In the third embodiment, the metasurface structure of the polarization control element 13a is configured to condense the polarization component P3 of the incident light La on the center of the pixel PX3a and condense the polarization component P4 of the incident light La on the center of the pixel PX4a. It is to be noted that a cross section taken along line 14-14 is similar to the cross section in FIG. 7, except for the widths of the meta-atoms 15, and thus, an illustration of the cross section taken along line 14-14 is omitted.

On the X-Y plane, the polarization directions of the polarization components P3 and P4 are inclined with respect to the polarization directions (the X axis and the Y axis) of the polarization components P1 and P2. For example, on the X-Y plane, the polarization direction of the polarization component P3 is inclined at an inclination angle $+\theta$ from the X direction. On the X-Y plane, the polarization direction of the polarization component P4 is inclined at an inclination angle $-\theta$ from the X direction. For example, $\theta$ may be set to 45 degrees. In this case, the polarization components P3 and P4 are substantially orthogonal to each other on the X-Y plane.

Multiple meta-atoms 15_3 (x, y) of the polarization control element 13a are inclined so as to have sides extending along the polarization direction of the polarization component P3. Multiple meta-atoms 15 4 (x, y) of the polarization control element 14a are inclined so as to have sides extending along the polarization direction of the polarization component P4.

Here, the position of a meta-atom having a maximum length in the polarization direction of the polarization components P3 and P4 depends on the distance from the center of the pixel region 20 to the pixel PX3a or PX4a. For example, in a case where the pixels PX3a and PX4a are positioned near the center of the pixel region 20, the incident light La is incident substantially from the Z direction. A meta-atom 15_3 (0, 0) which is located substantially in the center of the pixel PX3a has a maximum length in the polarization direction of the polarization component P3 of the incident light La. Also, a meta-atom 15_4 (0, 0) which is located substantially in the center of the pixel PX4a has a maximum length in the polarization direction of the polarization component P4 of the incident light La.

In the polarization direction of the polarization component P3, a length Dxy3 (0, 0) of the meta-atom 15_3 (0, 0) is maximum in the pixels PX3a and PX4a. The length Dxy3 (x, y) in the polarization direction becomes gradually shorter with an increase of the distance from the meta-atom 15_3 (0, 0) (the center of the pixel PX3a). Therefore, the length of the meta-atom 15_3 (x, y) in the polarization direction of the polarization component P3 depends on the distance from the center of the pixel PX3a. It is to be noted that the lengths Dxy3 (x, y) and Dxy4 (x, y) each indicate a length in the polarization direction of the polarization component P3. Lengths Dyx3 (x, y) and Dyx4 (x, y) each indicate a length in the polarization direction of the polarization component P4.

In the polarization direction of the polarization component P4, a length Dxy4 (0, 0) of the meta-atom 15_4 (0, 0) is maximum in the pixels PX3a and PX4a. The length Dxy4 (x, y) in the polarization direction becomes gradually shorter with an increase of the distance from the meta-atom 15_4 (0, 0) (the center of the pixel PX4a). Therefore, the length of the meta-atom 15_4 (x, y) in the polarization direction of the polarization component P4 depends on the distance from the center of the pixel PX4a.

FIG. 14B is a plan view of one example of the metasurface structures of the polarization control elements 13b and 14b according to the third embodiment. In a case where, like the pixels PX1b and PX2b in FIG. 11, pixels are positioned near an end (1.0 image height) of the pixel region 20, the inclined light Lb is incident from a direction that is inclined from the Z direction. In this case, a meta-atom that is deviated from the center of the pixel has a maximum length in the polarization direction of the polarization component P3 of the inclined light Lb, in a manner similar to that in the first embodiment. For example, a meta-atom 15_3 (1, 1), which is shifted from the center of the pixel toward the inclination direction of the inclined light Lb by a prescribed offset amount, is determined as a meta-atom having a maximum length. The shift amount of the meta-atom 15_3 (1, 1) having a maximum length from the center of the pixel PX3b (offset amount from the center of the pixel PX3b) depends on the distance from the center of the pixel region 20 to the pixel and increases with an increase of the distance. In other words, the shift amount (offset amount) of the meta-atom 15_3 (1, 1) having a maximum length depends on the inclination angle of the inclined light Lb. The shift amount increases with an increase of the inclination angle.

The similar increase applies also to the polarization direction of the polarization component P4 of the inclined light Lb. A meta-atom that is deviated from the center of the pixel has a maximum length in the polarization direction of the polarization component P4 of the inclined light Lb. For example, a meta-atom 15_4 (1, 1), which is shifted from the center of the pixel toward the inclination direction of the inclined light Lb by a prescribed offset amount, is determined as a meta-atom having a maximum length. The shift amount (offset amount) of the meta-atom 15_4 (1, 1) having a maximum length depends on the distance from the center of the pixel region 20 to the pixel and increases with an increase of the distance. In other words, the shift amount (offset amount from the center of the pixel PX4b) of the meta-atom 15_4 (1, 1) having a maximum length depends on the inclination angle of the inclined light Lb. The shift amount increases with an increase of the inclination angle.

Therefore, the metasurface structures of the polarization control elements further can perform exit pupil correction on the polarization components P3 and P4 which are inclined with respect to the polarization components P1 and P2 and can condense the components on the centers of the pixels PX1a and PX2a or the pixels PX1b and PX2b, which are located in given positions in the pixel region 20.

The remaining configurations of the third embodiment may be identical to those of the first embodiment. Accordingly, the third embodiment can provide the similar effect to the first embodiment. Also, the third embodiment may be combined with the second embodiment.

(Size of meta-atom)

FIG. 15 is an explanatory diagram depicting the plane size of a meta-atom 15 corresponding to the polarization components P1 and P2. One meta-atom 15 is provided within a range having a pitch PCHx in the X direction and a pitch PCHy in the Y direction. The length of the pitch PCHx and the length of the pitch PCHy are obtained as follows. In a case where a longer side and a shorter size of the meta-atom 15 are substantially parallel with the pitch PCHx and the pitch PCHy, respectively,

$$PCHx \geq \text{longer side of the meta-atom (expression 1)},$$

and

$$PCHy \geq \text{longer side of the meta-atom (expression 2)}.$$

In a case where a longer side and a shorter size of the meta-atom 15 are inclined with respect to the pitch PCHx or the pitch PCHy,

$$PCHx \geq \text{longer side + shorter side of the meta-atom (expression 3)},$$

and

$$PCHy \geq \text{longer side + shorter side of the meta-atom (expression 4)}.$$

The meta-atom 15 is provided within the range defined by the pitch PCHx and the pitch PCHy. Thus, the length Dx (x, y) of the meta-atom 15 is equal to or shorter than the pitch PCHx. The length Dy (x, y) of the meta-atom 15 is equal to or shorter than the pitch PCHy. In other words, the maximum length, in the X direction, of the meta-atoms 15 corresponding to the polarization components P1 and P2 is equal to the pitch PCHx while the maximum length in the Y direction of the meta-atoms 15 is equal to the pitch PCHy.

FIG. 16 is an explanatory diagram depicting the plane size of a meta-atom 15 corresponding to the polarization components P3 and P4. In a case where the meta-atom 15 is inclined at an angle of θ, for example, the length Dxy (x, y) of a longer side and the length Dyx (x, y) of a shorter side of the meta-atom 15 preferably satisfy expressions 5 and 6 below.

$$Dxy\ (x,\ y)\cos\theta + Dyx\ (x,\ y)\sin\theta \leq PCHx \quad \text{(expression 5)}$$

$$Dxy\ (x,\ y)\sin\theta + Dyx\ (x,\ y)\cos\theta \leq PCHy \quad \text{(expression 6)}$$

Accordingly, the meta-atom 15 is provided within the range of the pitch PCHx and the pitch PCHy.

When θ is 45 degrees, the maximum value of the meta-atom 15 is indicated by a diagonal line (maximum value) of the region of the pitches PCHx and PCHy. Accordingly, (Dxy (x, y) + Dyx (x, y))/√2 is equal to or less than PCHx, and further, (Dxy (x, y) + Dyx (x, y))/A/2 is equal to or less than PCHy.

If the meta-atom 15 is larger than the region of the pitches PCHx and PCHy, phase delay amounts of the incident light La and incident light Lb to be given in a single cycle are deviated.

However, when the meta-atom 15 satisfies the expressions 5 and 6, deviation of the phase delay amounts of the incident light La and the incident light Lb can be suppressed. Consequently, degradation in polarization separation and light condensation properties can be suppressed.

(Fourth Embodiment)

FIG. 17 is a plan view of one example of the metasurface structure of a polarization control element according to a fourth embodiment. The fourth embodiment is a combination of the first embodiment and the third embodiment. In the fourth embodiment, the polarization control elements 11a to 14a corresponding to four pixels PX1a to PX4a are arranged so as to be adjacent to be each other and condense polarization components P1 to P4 of the incident light La on the centers of the pixels PX1a to PX4a, respectively.

A set including the four polarization control elements 11a to 14a is repeatedly arranged in the pixel region 20. Accordingly, the polarization control elements 11a to 14a can perform exit pupil correction on the polarization components P1 to P4 and can condense the polarization components P1 to P4 on the centers of the pixels PX1a to PX4a, respectively.

At an end of the pixel region 20, which is not depicted in FIG. 17, a meta-atom having a maximum length is determined in a position that is shifted from the center of the pixel by a prescribed offset amount according to the incidence angle and the inclination direction of the inclined light Lb. As a result, the pixels PX1a to PX4a can precisely detect the light intensities of the polarization components P1 to P4 of the incident light La.

(Relation between incident light of incident light L and the position of a meta-atom having a maximum length)

FIGS. 18A to 19B are explanatory diagrams each depicting the relation between an incidence angle of the incident light L and the position of a meta-atom having a maximum length. It is to be noted that a meta-atom having a maximum length in the polarization direction (X direction) of the polarization component P1 will be explained and an explanation of the meta-atoms having the maximum lengths in the polarization directions of the polarization components P2 to P4 will be omitted. In addition, the offset amount of a meta-atom having a maximum length can be optionally determined. Therefore, the offset amount of a meta-atom having a maximum length in FIGS. 18A to 20B is different from the offset amount of the meta-atom having a maximum length in FIG. 11. However, this does not matter.

In a polarization control element that corresponds to the pixel PX1a which is located in the center of the pixel region 20, as depicted in FIG. 1, the meta-atom 15_1 (0, 0) in the center of the pixel PX1a has a maximum length in the polarization direction (X direction), as depicted in FIG. 4.

As depicted in FIG. 18A, inclined light Lc which is inclined toward the +X direction from the Z axis is incident on a pixel PX5 that is located at the -X direction end of the pixel region 20, as depicted in FIG. 18A. In a polarization control element 16 that corresponds to the pixel PX5, the meta-atom 15_1 (2, 0) which is located at the +X direction end of the pixel PX5 has a maximum length in the polarization direction (X direction), as depicted in FIG. 18B, for example. The length, in the polarization direction, of the meta-atom 15_1 (x, y) in the pixel PX5 becomes shorter with an increase of the distance from the meta-atom 15_1 (2, 0) having a maximum length.

As depicted in FIG. 19A, inclined light Ld which is inclined toward the +Y direction from the Z axis is incident on a pixel PX6 that is located at the -Y direction end of the pixel region 20. In a polarization control element 17 that corresponds to the pixel PX6, for example, as depicted in FIG. 19B, the meta-atom 15_1 (0, 2) which is located at the +Y direction end of the pixel PX6 has a maximum length in the polarization direction (X direction). The length, in the polarization direction, of the meta-atom 15_1 (x, y) in the pixel PX6 becomes shorter with an increase of the distance from the meta-atom 15_1 (0, 2) having a maximum length.

As depicted in FIG. 20A, inclined light Le which is inclined toward the +Y direction and the -Y direction from the Z axis is incident on a pixel PX7 that is located at a corner of the pixel region 20 in the -Y direction and +X direction. In a polarization control element 18 that corresponds to the pixel PX7, the meta-atom 15_1 (-2, 2) which is located at the +Y direction and -X direction end of the pixel PX7 has a maximum length in the polarization direction (X direction), as depicted in FIG. 20B, for example. The length, in the polarization direction, of the meta-atom 15_1 (x, y) in the pixel PX7 becomes shorter with an increase of the distance from the meta-atom 15_1 (-2, 2) having a maximum length.

In such a manner, the distance from the position of a meta-atom that has a maximum length in a pixel to the center of the pixel increases with an increase of the distance from the center of the pixel region 20 to the pixel. In addition, the distance from the position of a meta-atom in the pixel to the center of the pixel increases with an increase of the inclination angle of incident light with respect to the Z direction.

It is to be noted that the number of meta-atoms corresponding to each pixel is not limited to a specific number and can be optionally determined.

(Fifth Embodiment)

FIG. 21 is a cross-sectional view of a configuration example of the polarization control elements 11a to 11c according to a fifth embodiment. In the fifth embodiment, the multiple polarization control elements 11a to 11c are layered above the one pixel PX1a. The multiple polarization control elements 11a to 11c may have different metasurface structures. For example, the polarization control elements 11a to 11c may perform polarization control on rays of incident light of different colors (wavelengths). Consequently, the polarization control elements 11a to 11c can perform polarization control on incident light having a wide band. For example, the positions of the metasurface structures and the meta-atom sizes in the polarization control elements 11a, 11b, ..., 11c may be different from each other little by little. Accordingly, the phase delay amount can be gradually polarized.

The technology according to the present disclosure is applicable to electronic apparatuses of any type having an imaging function, such as camera systems including digital still cameras and video cameras, and mobile phones having an imaging function, for example.

Further, the present technology can adopt the following configurations.

(1) A solid-state imaging device including:

a pixel region that includes multiple pixels; and

a polarization control element that is disposed above an incidence surface of the pixel region on which incident light is incident and that includes multiple microstructures which are two-dimensionally arranged in substantially parallel with the incidence surface, in which,

of the multiple microstructures corresponding to a first pixel included in the pixel region, a first microstructure has a maximum length in a first polarization direction of the incident light, and a position of the first microstructure in the first pixel depends on a distance from a center of the pixel region to the first pixel.

(2) The solid-state imaging device according to (1), in which

a distance from the position of the first microstructure in the first pixel to a center of the first pixel increases with an increase of the distance from the center of the pixel region to the first pixel.

(3) The solid-state imaging device according to (1) or (2), in which

a distance from the position of the first microstructure in the first pixel to a center of the first pixel increases with an increase of an inclination angle of the incident light with respect to a direction perpendicular to the incidence surface.

(4) The solid-state imaging device according to any one of (1) to (3), in which,

of the multiple microstructures corresponding to a second pixel included in the pixel region, a second microstructure has a maximum length in a second polarization direction of the incident light substantially orthogonal to the first polarization direction, and a position of the second microstructure in the second pixel depends on a distance from the center of the pixel region to the second pixel.

(5) The solid-state imaging device according to (4), in which

a distance from the position of the second microstructure in the second pixel to a center of the second pixel increases with an increase of the distance from the center of the pixel region to the second pixel.

(6) The solid-state imaging device according to (4) or (5), in which

a distance from the position of the second microstructure in the second pixel to a center of the second pixel increases with an increase of an inclination angle of the incident light with respect to a direction perpendicular to the incidence surface.

(7) The solid-state imaging device according to any one of (1) to (6), in which,

in the first pixel, the multiple microstructures have, in the first polarization direction, a length that becomes shorter with an increase of a distance from the first microstructure.

(8) The solid-state imaging device according to any one of (4) to (6), in which,

in the second pixel, the multiple microstructures have, in the second polarization direction, a length that becomes shorter with an increase of a distance from the second microstructure.

(9) The solid-state imaging device according to any one of (1) to (8), in which

the multiple microstructures have, in the first polarization direction, a length that is restored to be equal to a length of the first microstructure, at every given distance from the first microstructure.

(10) The solid-state imaging device according to any one of (4) to (6) and (8), in which

the multiple microstructures have, in the second polarization direction, a length that is restored to be equal to the length of the second microstructure, at every given distance from the second microstructure.

(11) The solid-state imaging device according to any one of (1) to (10), in which,

of the multiple microstructures corresponding to a third pixel included in the pixel region, a third microstructure has a maximum length in a third polarization direction that is inclined from the first and second polarization directions of the incident light, and a position of the third microstructure in the third pixel depends on a distance from the center of the pixel region to the third pixel.

(12) The solid-state imaging device according to (11), in which

a distance from the position of the third microstructure in the third pixel to a center of the third pixel increases with an increase of the distance from the center of the pixel region to the third pixel.

(13) The solid-state imaging device according to (11) or (12), in which

a distance from the position of the third microstructure in the third pixel to a center of the third pixel increases with an increase of an inclination angle of the incident light with respect to a direction perpendicular to the incidence surface.

(14) The solid-state imaging device according to any one of (1) to (13), further including:

multiple polarization control elements that are disposed above the incidence surface and are layered.

It is to be noted that the present disclosure is not limited to the aforementioned embodiments, and various modifications can be made within the scope of the gist of the present disclosure. In addition, the effects described in the present description are just examples, and thus, are not limited. Any other effect may be further provided.

[Reference Signs List]

1: Image sensor
OP: Optical system
10: Polarization control unit
20: Pixel region
PX1a to PX2b: Pixel
11a to 12b: Polarization control element
30: Waveguide
15: Meta-atom

**Claims**

1. A solid-state imaging device comprising:

a pixel region that includes multiple pixels; and
a polarization control element that is disposed above an incidence surface of the pixel region on which incident light is incident and that includes multiple microstructures which are two-dimensionally arranged in substantially parallel with the incidence surface, wherein,
of the multiple microstructures corresponding to a first pixel included in the pixel region, a first microstructure has a maximum length in a first polarization direction of the incident light, and a position of the first microstructure in the first pixel depends on a distance from a center of the pixel region to the first pixel.

2. The solid-state imaging device according to claim 1, wherein
a distance from the position of the first microstructure in the first pixel to a center of the first pixel increases with an increase of the distance from the center of the pixel region to the first pixel.

3. The solid-state imaging device according to claim 1, wherein
a distance from the position of the first microstructure in the first pixel to a center of the first pixel increases with an increase of an inclination angle of the incident light with respect to a direction perpendicular to the incidence surface.

4. The solid-state imaging device according to claim 1, wherein,
of the multiple microstructures corresponding to a second pixel included in the pixel region, a second microstructure has a maximum length in a second polarization direction of the incident light substantially orthogonal to the first polarization direction, and a position of the second microstructure in the second pixel depends on a distance from the center of the pixel region to the second pixel.

5. The solid-state imaging device according to claim 4, wherein
a distance from the position of the second microstructure in the second pixel to a center of the second pixel increases with an increase of the distance from the center of the pixel region to the second pixel.

6. The solid-state imaging device according to claim 4, wherein
a distance from the position of the second microstructure in the second pixel to a center of the second pixel increases with an increase of an inclination angle of the incident light with respect to a direction perpendicular to the incidence surface.

7. The solid-state imaging device according to claim 1, wherein,
in the first pixel, the multiple microstructures have, in the first polarization direction, a length that becomes shorter with an increase of a distance from the first microstructure.

8. The solid-state imaging device according to claim 4, wherein,
in the second pixel, the multiple microstructures have, in the second polarization direction, a length that becomes shorter with an increase of a distance from the second microstructure.

9. The solid-state imaging device according to claim 1, wherein

the multiple microstructures have, in the first polarization direction, a length that is restored to be equal to a length of the first microstructure, at every given distance from the first microstructure.

10. The solid-state imaging device according to claim 4, wherein
the multiple microstructures have, in the second polarization direction, a length that is restored to be equal to the length of the second microstructure, at every given distance from the second microstructure.

11. The solid-state imaging device according to claim 1, wherein,
of the multiple microstructures corresponding to a third pixel included in the pixel region, a third microstructure has a maximum length in a third polarization direction that is inclined from the polarization direction of the incident light, and a position of the third microstructure in the third pixel depends on a distance from the center of the pixel region to the third pixel.

12. The solid-state imaging device according to claim 11, wherein
a distance from the position of the third microstructure in the third pixel to a center of the third pixel increases with an increase of the distance from the center of the pixel region to the third pixel.

13. The solid-state imaging device according to claim 11, wherein
a distance from the position of the third microstructure in the third pixel to a center of the third pixel increases with an increase of an inclination angle of the incident light with respect to a direction perpendicular to the incidence surface.

14. The solid-state imaging device according to claim 1, further comprising:
multiple polarization control elements that are disposed above the incidence surface and are layered.

# FIG.1

FIG.2

# FIG.3

# FIG.4

15_1 (0,2)

Dx (0,2)    15_1 (0,1)

15_1(0,0)
15_1(-1,0)
15_1(-2,0)

15_1 (1,0)
15_1 (2,0)

3 ——— Dx (0,1) ——— 3

Dx (-2,0)    Dx (-1,0)    Dx (0,0)    Dx (1,0)    Dx(2,0)

15_1 (0,-1)

Dx (0,-1)

Dx (0,-2)    15_1 (0,-2)

PX1a

Y
Z — X

# FIG.5

FIG.6

# FIG.7

FIG. 8

FIG.9

POSITION DELAY AMOUNT (rad/2n)

0

15_1(-2,0)　　15_1(-1,0)　　15_1(0,0)　　15_1(1,0)　　15_1(2,0)

X (μm)

FIG.10

POSITION DELAY AMOUNT (rad/2n)

0

15_2(-2,0)　　15_2(-1,0)　　15_2(0,0)　　15_2(1,0)　　15_2(2,0)

X (μm)

EP 4 383 331 A1

FIG.11

# FIG.12

EP 4 383 331 A1

FIG.13

EP 4 383 331 A1

FIG.14A

EP 4 383 331 A1

F I G . 1 4 B

# FIG.15

15

PCHy

Dy(x,y)

Dx(x,y)

PCHx

Y

θ

Z

X

# FIG.16

# FIG.17

La ⊗

P3
P1
P2
P4

La ⊗

13a    PX3a                                          PX4a    14a

15_3(0,0)                                            15_4(0,0)

Dxy3(0,0)                                            Dyx4(0,0)

Dy1(-2,0)  Dy1(-1,0)  Dy1(0,0)  Dy1(1,0)  Dy1(2,0)  Dy2(-2,0)  Dy2(-1,0)  Dy2(0,0)  Dy2(1,0)  Dy2(2,0)

15_1(-2,0)  15_1(-1,0)  15_1(0,0)  15_1(1,0)  15_1(2,0)  15_2(-2,0)  15_2(-1,0)  15_2(0,0)  15_2(1,0)  15_2(2,0)

Dx1(-2,0)  Dx1(-1,0)  Dx1 (0,0)  Dx1(1,0)  Dx1(2,0)  Dx2(-2,0)  Dx2(-1,0)  Dx2(0,0)  Dx2(1,0)  Dx2(2,0)

11a    PX1a                                          PX2a    12a

Y
Z ⊗ → X

# F I G . 1 8 A

# F I G . 1 8 B

# FIG.19A

# FIG.19B

# FIG.20A

# FIG.20B

# FIG.21

## INTERNATIONAL SEARCH REPORT

| International application No. |
| --- |
| **PCT/JP2022/013043** |

**A.    CLASSIFICATION OF SUBJECT MATTER**

*H01L 27/146*(2006.01)i; *G02B 5/30*(2006.01)i
FI:    H01L27/146 D; G02B5/30

According to International Patent Classification (IPC) or to both national classification and IPC

**B.    FIELDS SEARCHED**

Minimum documentation searched (classification system followed by classification symbols)

H01L27/146; G02B5/30

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

**C.    DOCUMENTS CONSIDERED TO BE RELEVANT**

| Category* | Citation of document, with indication, where appropriate, of the relevant passages | Relevant to claim No. |
| --- | --- | --- |
| A | JP 2020-51868 A (NIPPON TELEGRAPH & TELEPHONE) 02 April 2020 (2020-04-02) entire text, all drawings | 1-14 |
| A | JP 2020-80366 A (SONY SEMICONDUCTOR SOLUTIONS CORP) 28 May 2020 (2020-05-28) entire text, all drawings | 1-14 |
| A | JP 2017-215330 A (MITSUBISHI ELECTRIC CORP) 07 December 2017 (2017-12-07) entire text, all drawings | 1-14 |
| A | JP 2010-8990 A (CANON INC) 14 January 2010 (2010-01-14) entire text, all drawings | 1-14 |
| A | JP 2015-115329 A (CANON INC) 22 June 2015 (2015-06-22) entire text, all drawings | 1-14 |
| A | US 2020/0321378 A1 (TRUSTEES OF BOSTON UNIVERSITY) 08 October 2020 (2020-10-08) entire text, all drawings | 1-14 |

☑ Further documents are listed in the continuation of Box C.    ☑ See patent family annex.

| | |
| --- | --- |
| *    Special categories of cited documents: <br> "A"    document defining the general state of the art which is not considered to be of particular relevance <br> "E"    earlier application or patent but published on or after the international filing date <br> "L"    document which may throw doubts on priority claim(s) or which is cited to establish the publication date of another citation or other special reason (as specified) <br> "O"    document referring to an oral disclosure, use, exhibition or other means <br> "P"    document published prior to the international filing date but later than the priority date claimed | "T"    later document published after the international filing date or priority date and not in conflict with the application but cited to understand the principle or theory underlying the invention <br> "X"    document of particular relevance; the claimed invention cannot be considered novel or cannot be considered to involve an inventive step when the document is taken alone <br> "Y"    document of particular relevance; the claimed invention cannot be considered to involve an inventive step when the document is combined with one or more other such documents, such combination being obvious to a person skilled in the art <br> "&"    document member of the same patent family |

| Date of the actual completion of the international search | Date of mailing of the international search report |
| --- | --- |
| **09 June 2022** | **21 June 2022** |

| Name and mailing address of the ISA/JP | Authorized officer |
| --- | --- |
| **Japan Patent Office (ISA/JP)** <br> **3-4-3 Kasumigaseki, Chiyoda-ku, Tokyo 100-8915** <br> **Japan** | |
| | Telephone No. |

Form PCT/ISA/210 (second sheet) (January 2015)

<table>
<tr><td colspan="2" align="left">**INTERNATIONAL SEARCH REPORT**</td><td colspan="2">International application No.<br>**PCT/JP2022/013043**</td></tr>
<tr><td colspan="4">**C.    DOCUMENTS CONSIDERED TO BE RELEVANT**</td></tr>
<tr><td>Category*</td><td colspan="2">Citation of document, with indication, where appropriate, of the relevant passages</td><td>Relevant to claim No.</td></tr>
<tr><td>A</td><td colspan="2">WO 2017/187804 A1 (SHARP KABUSHIKI KAISHA) 02 November 2017 (2017-11-02)<br>entire text, all drawings</td><td>1-14</td></tr>
<tr><td>A</td><td colspan="2">JP 2015-28960 A (SONY CORP) 12 February 2015 (2015-02-12)<br>entire text, all drawings</td><td>1-14</td></tr>
<tr><td>A</td><td colspan="2">WO 2014/097507 A1 (PANASONIC CORPORATION) 26 June 2014 (2014-06-26)<br>entire text, all drawings</td><td>1-14</td></tr>
</table>

Form PCT/ISA/210 (second sheet) (January 2015)

INTERNATIONAL SEARCH REPORT
Information on patent family members

International application No.

**PCT/JP2022/013043**

| Patent document cited in search report | | | Publication date (day/month/year) | Patent family member(s) | | | Publication date (day/month/year) |
|---|---|---|---|---|---|---|---|
| JP | 2020-51868 | A | 02 April 2020 | US | 2021/0333151 | A1 | |
| | | | | entire text, all drawings | | | |
| JP | 2020-80366 | A | 28 May 2020 | US | 2021/0389184 | A1 | |
| | | | | entire text, all drawings | | | |
| JP | 2017-215330 | A | 07 December 2017 | (Family: none) | | | |
| JP | 2010-8990 | A | 14 January 2010 | US | 2010/0220377 | A1 | |
| | | | | entire text, all drawings | | | |
| | | | | KR | 10-2010-0032447 | A | |
| | | | | CN | 101730857 | A | |
| JP | 2015-115329 | A | 22 June 2015 | (Family: none) | | | |
| US | 2020/0321378 | A1 | 08 October 2020 | WO | 2019/075335 | A1 | |
| | | | | entire text, all drawings | | | |
| WO | 2017/187804 | A1 | 02 November 2017 | US | 2019/0162890 | A1 | |
| | | | | entire text, all drawings | | | |
| | | | | CN | 109075178 | A | |
| JP | 2015-28960 | A | 12 February 2015 | (Family: none) | | | |
| WO | 2014/097507 | A1 | 26 June 2014 | (Family: none) | | | |

Form PCT/ISA/210 (patent family annex) (January 2015)

**REFERENCES CITED IN THE DESCRIPTION**

**Patent documents cited in the description**

- JP 2020051868 A